# EUROPEAN PATENT APPLICATION

(11) **EP 4 506 703 A1**
(43) Date of publication of application: **12.02.2025**
(21) Application number: 23826721.5
(22) Date of filing: 21.02.2023
(51) Int. Cl.: G01R 31/392, B60L 3/00, B60L 58/16, G01R 31/388, H01M 10/42, H01M 10/48, H02J 7/00

(54) **BATTERY PACK**

(30) Priority: 21.06.2022 JP 2022099518
(71) Applicant: Kubota Corporation, Osaka 556-8601 (JP)
(72) Inventor: FUJII, Yasuo, Sakai-shi, Osaka 592-8331 (JP); KOYAMA, Kazuaki, Sakai-shi, Osaka 592-8331 (JP); HORITA, Tatsuhiko, Sakai-shi, Osaka 592-8331 (JP); NAGAMORI, Yuko, Sakai-shi, Osaka 592-8331 (JP); KIMURA, Ryota, Sakai-shi, Osaka 592-8331 (JP)
(74) Representative: Mewburn Ellis LLP
(86) International application number: PCT/JP2023/006220
(87) International publication number: WO 2023/248532

(57) **Abstract**

[Problem] To provide a battery pack capable of performing degradation diagnosis of a battery by a single body. [Solution] A battery pack 40 includes a battery 50 that supplies electric power to a motor 2 of a hybrid system 10, a resistor 45 that is electrically connected to the battery 50 by an electric circuit, a switch 46 that is provided in the electric circuit 174 between the battery 50 and the resistor 45 and performs opening / closing of the electric circuit 174 between the battery 50 and the resistor 45, and a control portion 85 that executes control of closing the switch 46 in accordance with an input signal 86 and diagnoses a degradation degree of the battery 50 on the basis of voltage fluctuation of the battery 50 when an electric current flows from the battery 50 toward the resistor 45.

## Description

### [Technical Field]

The present invention relates to a battery pack mounted on a hybrid system.

### [Background Art]

A hybrid system that concurrently uses an engine, a motor, and a battery has been developed for industrial machines, automobiles and the like in response to a request for lower pollution and resource saving of fossil fuel. The hybrid system includes, for example, an internal combustion engine that generates power by using the fossil fuel, a motor that assists the internal combustion engine, and a battery such as a lithium-ion battery or the like, for example, that supplies electric power to the motor.

In the hybrid system, a battery pack including the lithium-ion battery, for example, is used as a power supply for driving the motor. In the lithium-ion battery, such a degradation phenomenon occurs that a full-charge capacity is decreased by storage for a long time or a use for a long time. For example, in an automobile such as a passenger car having the hybrid system, a degradation degree of the lithium-ion battery can be regularly diagnosed easily by using a degradation diagnosing device at automobile inspection.

However, in the case of the industrial machine having the hybrid system, it is difficult to regularly diagnose the degradation degree of the lithium-ion battery, as there are no opportunities for regular inspections such as automobile inspections. For example, for a user using the industrial machine having the hybrid system, in order to perform diagnosis of the degradation degree of the lithium-ion battery, a battery evaluation device such as an expensive battery degradation-degree diagnosing device or the like needs to be prepared separately. As described above, since it is difficult to regularly diagnose the degradation degree of the lithium-ion battery in the industrial machine having the hybrid system, there is a problem that timing to replace the lithium-ion battery is not clear for the user.

PTL 1 discloses a method of cell degradation diagnosis of a battery for vehicle. PTL 2 discloses a battery-state determination system and a battery-state determination method that can perform determination of a degradation state of a battery mounted on a vehicle in a server device. PTL 3 discloses a degradation determining device and a degradation determining method of a secondary battery realized by an ECU (Engine Control Unit) mounted on an electromotive vehicle such as an electric automobile, a hybrid automobile and the like, for example.

However, with the arts described in PTL 1, PTL 2, and PTL 3, a control device, a detection device and the like for detecting a physical amount (electric current, voltage and the like) related to the state of the battery are mounted on the vehicle, which is required separately from the battery pack. Thus, there is a problem that it is difficult to perform the degradation diagnosis of a battery by a single body of the battery pack. That is, there is a problem that the degradation diagnosis of the battery can be performed only when the battery pack is mounted on the hybrid system.

### [Citation List]

### [Patent Literature]

[PTL 1] Japanese Patent Application Publication No. 2011-257372
[PTL 2] Japanese Patent Application Publication No. 2021-86654
[PTL 3] International Publication No. 2011/125213

### [Summary of Invention]

### [Technical Problem]

The present invention was made in view of the aforementioned circumstances and has an object to provide a battery pack capable of performing degradation diagnosis of a battery by a single body.

### [Solution to Problem]

A first aspect of the present invention is a battery pack mounted on a hybrid system, characterized by including a battery that supplies electric power to a motor of the hybrid system, a resistor electrically connected to the battery by an electric circuit, a switch provided in the electric circuit between the battery and the resistor and performing opening / closing of the electric circuit between the battery and the resistor, and a control portion that executes control of closing the switch in accordance with an input signal and diagnoses a degradation degree of the battery on the basis of voltage fluctuation of the battery when the electric current flows from the battery toward the resistor.

According to the first aspect of the present invention, the resistor is provided in the battery pack and is electrically connected to the battery by the electric circuit. Moreover, the switch is provided in the electric circuit between the battery and the resistor and performs opening / closing of the electric circuit between the battery and the resistor. Thus, when the switch closes the electric circuit between the battery and the resistor, the electric current flows from the battery toward the resistor. Here, the control portion provided in the battery pack executes control closing the switch in accordance with an input signal and diagnoses a degradation degree of the battery on the basis of the voltage fluctuation of the battery when the electric current flows from the battery toward the resistor. As a result, the battery pack according to the first aspect of the present invention can perform the degradation diagnosis of the battery provided in the battery pack by a single body of the battery pack. Moreover, since the battery pack according to the first aspect of the present invention can perform the degradation diagnosis of the battery by a single body of the battery pack, it can perform the degradation diagnosis of the battery by a signal input into the control portion at an arbitrary timing, and even if there is no chance for regular inspection such as automobile inspection or the like, for example, the degradation degree of the battery can be diagnosed at the arbitrary timing. As a result, replacement timing of the battery provided in the battery pack becomes clearer.

A second aspect of the present invention is, in the first aspect of the present invention, a battery pack is characterized in that the control portion executes control of automatically opening the switch when a predetermined time has elapsed since the switch was closed.

According to the second aspect of the present invention, the control portion can suppress occurrence of an over-discharge abnormality of the battery.

A third aspect of the present invention is, in the first aspect or the second aspect of the present invention, a battery pack characterized in that the control portion incorporates an internal circuit that detects a voltage value of the battery.

According to the third aspect of the present invention, even if a detecting portion that detects a voltage value of the battery is not provided separately, the control portion can detect the voltage value of the battery by the internal circuit incorporated in the control portion itself. As a result, a structure of the battery pack can be simplified, and size reduction of the battery pack can be promoted.

A fourth aspect of the present invention is, in any one of the first aspect to the third aspect of the present invention, a battery pack characterized by further including a positive-side contactor provided in the electric circuit between a positive terminal of the battery and the resistor and performing opening / closing of the electric circuit between the positive terminal and the resistor and a negative-side contactor provided in the electric circuit between a negative terminal of the battery and the resistor and performing opening / closing of the electric circuit between the negative terminal and the resistor, in which the switch is provided at least at either one of the electric circuit between the positive-side contactor and the resistor and the electric circuit between the negative-side contactor and the resistor.

According to the fourth aspect of the present invention, the switch that performs opening / closing of the electric circuit between the battery and the resistor is provided at least in either one of the electric circuit between the positive-side contactor and the resistor and the electric circuit between the negative-side contactor and the resistor. Thus, even when an abnormality such as overcurrent abnormality, for example, occurs in the electric circuit, the electric circuit on an upstream side of the switch viewed from the battery is shut down by opening of at least either one of the positive-side contactor and the negative-side contactor. As a result, safety of the battery pack can be improved.

A fifth aspect of the present invention is, in the fourth aspect of the present invention, a battery pack characterized by further including an electric-current detecting portion that is provided in the electric circuit and detects an electric-current value flowing through the electric circuit, in which, when the control portion detects an overcurrent abnormality on the basis of the electric-current value obtained from the electric-current detecting portion, the control portion executes control of opening the switch and executes control of opening at least either one of the positive-side contactor and the negative-side contactor.

According to the fifth aspect of the present invention, when the control portion detects the overcurrent abnormality on the basis of the electric-current value obtained from the electric-current value detecting portion, the control portion executes the control of opening the switch. Moreover, when the control portion detects the overcurrent abnormality on the basis of the electric-current value obtained from the electric-current value detecting portion, the control portion executes control of opening at least either one of the positive-side contactor and the negative-side contactor. As a result, even if the switch is welded and cannot be opened, for example, the control portion can shut down the electric circuit more reliably by opening at least either one of the positive-side contactor and the negative-side contactor. As a result, the safety of the battery pack can be further improved.

A sixth aspect of the present invention is, in any one of the first aspect to the fifth aspect of the present invention, a battery pack characterized in that the control portion has a storage portion that accumulates data of the voltage fluctuation and diagnoses the degradation degree on the basis of the data accumulated in the storage portion.

According to the sixth aspect of the present invention, since the control portion diagnoses degradation degree on the basis of data of the voltage fluctuation of the battery accumulated in the storage portion, the degradation degree of the battery can be estimated with higher accuracy, and the replacement timing of the battery can be made clearer.

### [Advantageous Effects of Invention]

According to the present invention, a battery pack capable of performing the degradation diagnosis of a battery by a single body can be provided.

### [Brief Description of Drawings]

[Fig. 1]

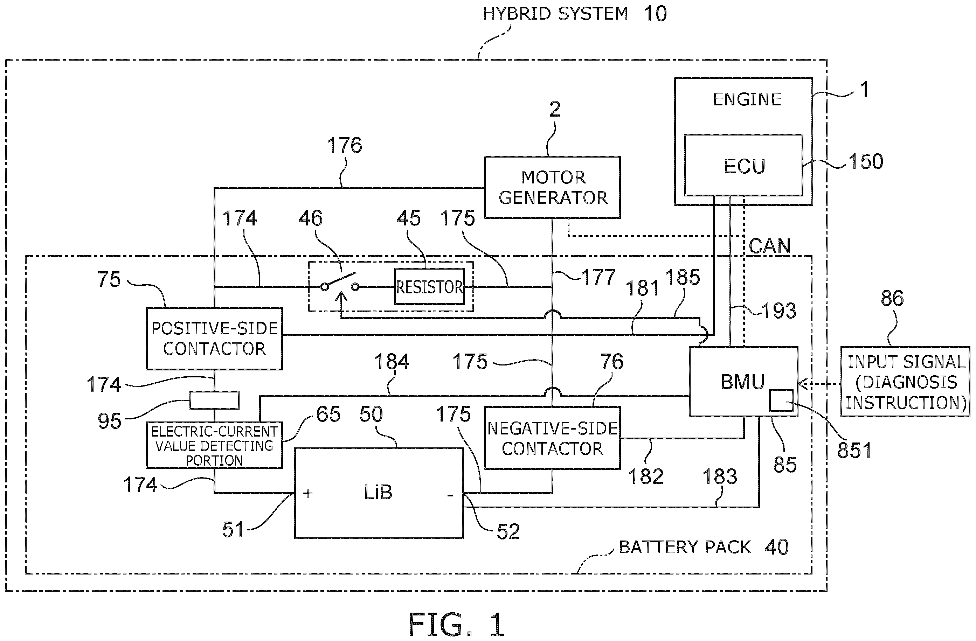

   Fig. 1 is a block diagram illustrating a hybrid system in which a battery pack according to an embodiment of the present invention is mounted.
[Fig. 2]

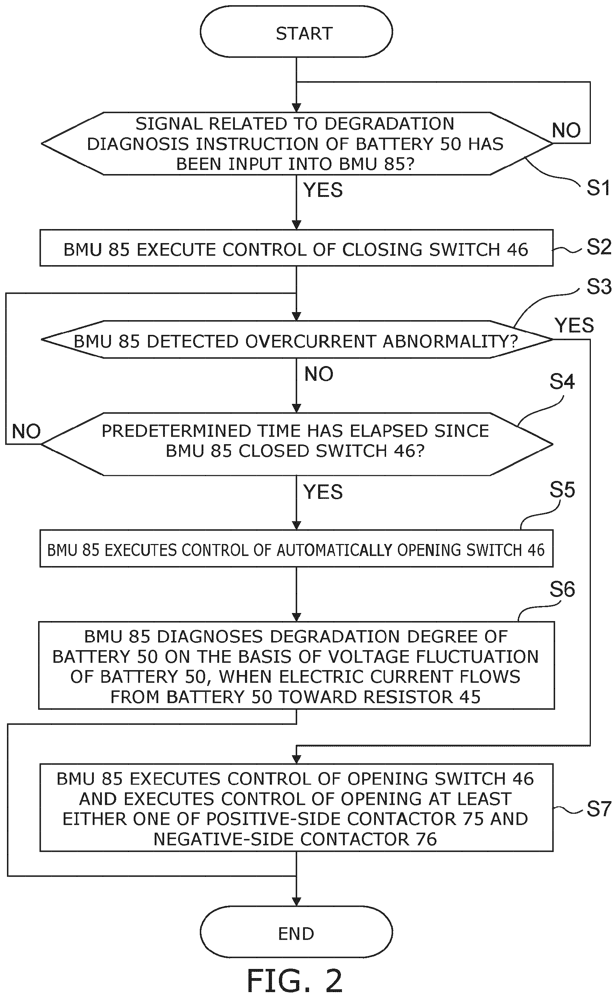

   Fig. 2 is a flowchart illustrating an operation example of battery degradation diagnosis executed by a battery pack according to this embodiment.
[Fig. 3]

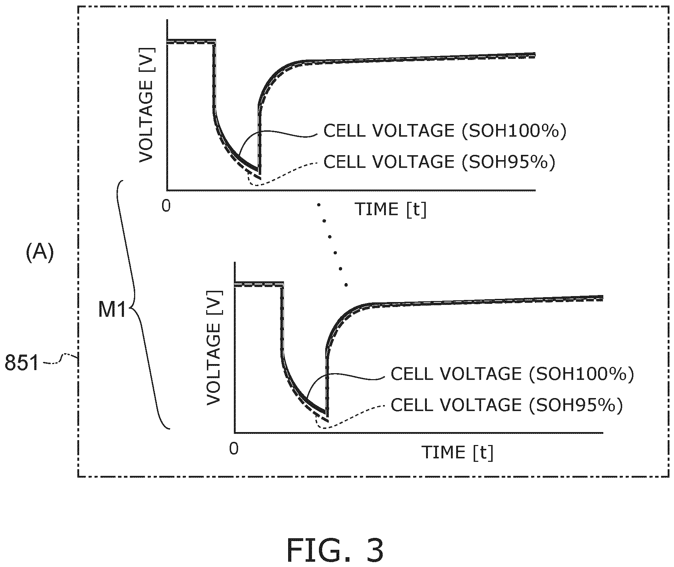

   Fig. 3 is a graph illustrating a behavior example of voltage fluctuation of a battery when an electric current flows from the battery toward a resistor.
[Fig. 4]

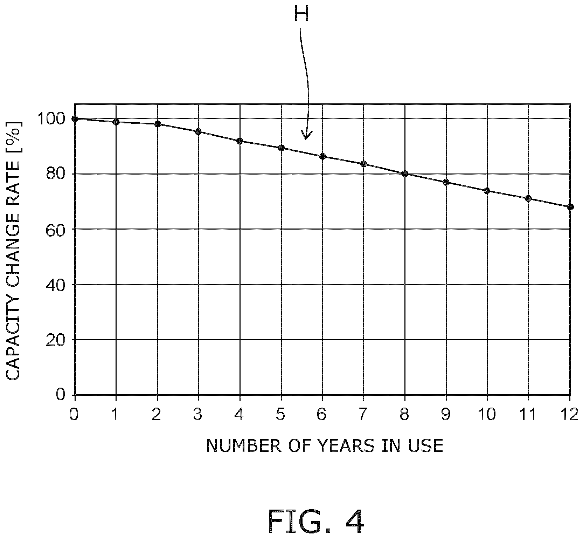

   Fig. 4 is a graph illustrating a change example of the degradation degree of the battery corresponding to the number of years in use of the battery.

### [Description of Embodiments]

Hereinafter, an embodiment of the present invention will be explained with reference to the drawings.

Note that the embodiment explained below is a preferred embodiment of the present invention and thus, technically preferable various limitations are given, but a range of the present invention is not limited to these aspects unless there is a description that limits the present invention in particular in the following explanation. Moreover, in each of the drawings, the same signs are given to the same constituent elements, and detailed explanation will be omitted as appropriate.

Fig. 1 is a block diagram illustrating a hybrid system on which a battery pack according to the embodiment of the present invention is mounted.

The hybrid system 10 shown in Fig. 1 includes an engine 1, a motor generator 2, and a battery pack 40. The motor generator 2 of this embodiment is an example of the "motor" of the present invention.

The engine 1 is a multi-cylinder diesel engine such as a supercharging-type high-output 3-cylinder engine having a turbocharger, a 4-cylinder engine or the like, for example. However, the engine 1 is not limited to the diesel engine. The engine 1 has an ECU (Engine Control Unit) 150. The ECU 150 controls an operation of the engine 1 and controls the motor generator 2 by performing communication with the motor generator 2 by a CAN (Controller Area Network), for example.

The motor generator 2 is operated by electric power supplied from the battery pack 40 and supports the engine 1, when power is required such as at start or at acceleration of an industrial machine or the like on which the hybrid system 10 is mounted. Note that the hybrid system 10 is mounted on the industrial machine or the like including a construction machine such as a forklift and an agricultural machine such as a tractor, for example. Moreover, the motor generator 2 generates power by converting kinetic energy of an industrial machine or the like on which the hybrid system 10 is mounted to electric energy using a regenerative brake or the like. The motor generator 2 incorporates an inverter. However, the inverter does not necessarily have to be incorporated in the motor generator 2 but may be provided as a body separated from the motor generator 2.

The battery pack 40 includes a battery 50, a resistor 45, a switch 46, and a BMU (Battery Management Unit) 85. The battery 50 is provided as a drive power-supply of the motor generator 2 and supplies electric power to the motor generator 2. The battery 50 has a positive terminal 51 and a negative terminal 52. As the battery 50, a high-voltage type lithium-ion battery (LiB) of 48 V can be cited, for example. However, the battery 50 is not limited to the lithium-ion battery. Moreover, the voltage of the battery 50 is not limited to 48 V but may be equal to or higher than 48 V.

The resistor 45 is electrically connected to the battery 50 by the electric circuit. Specifically, as shown in Fig. 1, the resistor 45 is connected to a positive wiring 174 connected to the positive terminal 51 of the battery 50 and is also connected to a negative wiring 175 connected to the negative terminal 52 of the battery 50. That is, the positive wiring 174 is a wiring which electrically connects the positive terminal 51 of the battery 50 and the resistor 45. The negative wiring 175 is a wiring which electrically connects the negative terminal 52 of the battery 50 and the resistor 45. Note that the motor generator 2 is connected to a positive branch wiring 176 branching from the positive wiring 174 and is also connected to a negative branch wiring 177 branching from the negative wiring 175. That is, as shown in Fig. 1, the electric circuit in which the resistor 45 and the motor generator 2 are connected to the battery 50 constitutes a parallel circuit.

The resistor 45 is used for causing the battery 50 to discharge when the BMU 85 diagnoses a degradation degree of the battery 50, that is, to cause the electric current to flow from the battery 50. Details thereof will be described later. The BMU 85 of this embodiment is an example of the "control portion" of the present invention.

The switch 46 is provided at the electric circuit between the battery 50 and the resistor 45. Specifically, as shown in Fig. 1, the switch 46 is provided at the positive wiring 174. That is, the electric circuit between the battery 50 and the resistor 45 includes the positive wiring 174. More specifically, the switch 46 is provided at the positive wiring 174 between a positive-side contactor 75 and the resistor 45. Note that the switch 46 may be provided at the negative wiring 175. In this case, the electric circuit between the battery 50 and the resistor 45 includes the negative wiring 175. More specifically, the switch 46 may be provided at the negative wiring 175 between a negative-side contactor 76 and the resistor 45.

The switch 46 is electrically connected to the BMU 85 by a signal line 185, and on the basis of a control signal transmitted via the signal line 185 from the BMU 85, opening / closing of the electric circuit between the battery 50 and the resistor 45, that is, the opening / closing of the positive wiring 174 is performed.

The battery pack 40 further has the positive-side contactor 75, the negative-side contactor 76, an electric-current value detecting portion 65, and a fuse 95. The positive-side contactor 75 is provided at the electric circuit between the positive terminal 51 of the battery 50 and the resistor 45, that is, at the positive wiring 174. The positive-side contactor 75 is electrically connected to the ECU 150 by a signal line 181 and performs opening / closing of the positive wiring 174 on the basis of a control signal transmitted from the ECU 150 via the signal line 181.

Note that the positive-side contactor 75 may be electrically connected to the BMU 85. In this case, the positive-side contactor 75 performs opening / closing of the positive wiring 174 on the basis of the control signal transmitted from the BMU 85.

The negative-side contactor 76 is provided at the electric circuit between the negative terminal 52 of the battery 50 and the resistor 45, that is, at the negative wiring 175. The negative-side contactor 76 is electrically connected to the BMU 85 by a signal line 182 and performs opening / closing of the negative wiring 175 on the basis of the control signal transmitted from the BMU 85 via the signal line 182.

Note that the negative-side contactor 76 may be electrically connected to the ECU 150. In this case, the negative-side contactor 76 performs opening / closing of the negative wiring 175 on the basis of the control signal transmitted from the ECU 150.

The BMU 85 is electrically connected to the battery 50 by a signal line 183 and detects a voltage value of the battery 50 on the basis of the signal transmitted from the battery 50 via the signal line 183. Specifically, the BMU 85 detects a voltage value of each cell incorporated in the battery 50 by using the internal circuit incorporated in the BMU 85 itself and detects the total sum of the voltage values of the respective cells as a voltage value of the battery 50. The BMU 85 is monitoring a state of the battery 50 and can detect an abnormality of the battery 50 on the basis of a signal transmitted from the battery 50 via the signal line 183. For example, the BMU 85 detects a voltage value of the battery 50 on the basis of the signal transmitted from the battery 50 via the signal line 183 and detects an overcharge abnormality and an over-discharge abnormality.

The BMU 85 is electrically connected to the electric-current value detecting portion 65 by a signal line 184 and obtains the electric-current value from the electric-current value detecting portion 65 via the signal line 184. The electric-current value detecting portion 65 is provided at the positive wiring 174 and detects an electric-current value flowing through the positive wiring 174. That is, the BMU 85 obtains the electric-current value flowing through the positive wiring 174 from the electric-current value detecting portion 65 via the signal line 184. The BMU 85 detects the overcurrent abnormality on the basis of the electric-current value obtained from the electric-current value detecting portion 65 via the signal line 184. Alternatively, the BMU 85 detects an over-temperature abnormality on the basis of a cell temperature obtained from a CMU (Cell Management Unit; not shown).

Moreover, the BMU 85 is electrically connected to the ECU 150 by a signal line 193 and controls the negative-side contactor 76 on the basis of a control signal transmitted from the ECU 150 via the signal line 193. The ECU 150 and the BMU 85 communicate with each other by the CAN, for example, and mutually monitor the state of the other.

The BMU 85 has a storage portion 851.

The fuse 95 is provided at the positive wiring 174 between the electric-current value detecting portion 65 and the positive-side contactor 75. The fuse 95 shuts down the electric circuit, that is, the positive wiring 174, when an overcurrent flows through the positive wiring 174.

Here, when the battery pack is mounted on an industrial machine, since there is no chance for regular inspection such as automobile inspection, it is difficult to regularly diagnose a degradation degree of a battery (lithium-ion battery, for example). Thus, timing for replacement of the battery is unclear for a user. Moreover, when a physical amount related to the state of the battery (an electric current, a voltage and the like) is detected by another control device or detecting device different from the battery pack, it is difficult to perform the degradation diagnosis of a battery by a single body of the battery pack. For example, the degradation diagnosis of the battery can be performed only when the battery pack is mounted on the hybrid system.

On the other hand, the BMU 85 of the battery pack 40 according to this embodiment executes control of closing the switch 46 in accordance with the input signal 86 related to a degradation diagnosis instruction of the battery 50. The input signal 86 is input from a service man or a user to the BMU 85 at an arbitrary timing by the CAN, an analog switch or the like. As an example of the "arbitrary timing", a timing in a production process or in an inspection process before the battery pack 40 is shipped from a plant can be cited, for example. Moreover, as the example of the "arbitrary timing", a timing at regular inspection after the battery pack 40 is assembled in the hybrid system 10 and mounted on a real machine or irregular inspection can be cited, for example.

Note that the "arbitrary timing" after the battery pack 40 is mounted on the real machine is preferably a timing when the motor generator 2 is not operating. According to this, the BMU 85 can diagnose the degradation degree of the battery 50 at a timing when the voltage of the battery 50 is relatively stable. As a result, the BMU 85 can diagnose the degradation degree of the battery 50 more stably and with higher accuracy.

Subsequently, when a predetermined time has elapsed since the BMU 85 closed the switch 46, the BMU 85 executes control of automatically opening the switch 46. The "predetermined time" is approximately 8 seconds or more and 12 seconds or less, for example. However, the "predetermined time" is not limited to 8 seconds or more and 12 seconds or less. Subsequently, the BMU 85 diagnoses the degradation degree of the battery 50 on the basis of voltage fluctuation of the battery 50 when the electric current flows from the battery 50 toward the resistor 45. Note that the timing when the BMU 85 diagnoses the degradation degree of the battery 50 does not necessarily have to be after the BMU 85 opened the switch 46 but may be before the BMU 85 opens the switch 46. That is, the BMU 85 may diagnose the degradation degree of the battery 50 when the switch 46 is closed.

A battery degradation diagnosis sequence of this embodiment is stored in the storage portion 851 of the BMU 85 in advance.

Subsequently, an operation example that the battery pack 40 according to this embodiment diagnoses the degradation degree of the battery 50 will be explained with reference to the drawings.

Fig. 2 is a flowchart illustrating an operation example of the battery degradation diagnosis performed by the battery pack according to this embodiment.

Fig. 3 is a graph illustrating a behavior example of the voltage fluctuation of the battery when the electric current flows from the battery toward the resistor.

Fig. 4 is a graph illustrating a change example of the degradation degree of the battery in accordance with the number of years in use of the battery.

At Step S1 shown in Fig. 2, the BMU 85 determines whether or not a signal related to the degradation diagnosis instruction of the battery 50 (that is, the input signal 86: see Fig. 1) has been input to the BMU 85. An example of the timing when the input signal 86 is input into the BMU 85 is as described above in relation with Fig. 1.

If the signal related to the degradation diagnosis instruction of the battery 50 has been input into the BMU 85 (Step S1: YES), at Step S2, the BMU 85 executes control of closing the switch 46. Subsequently, at Step S3, the BMU 85 determines whether or not an overcurrent abnormality has been detected on the basis of an electric-current value obtained from the electric-current value detecting portion 65.

When the BMU 85 detects an overcurrent abnormality on the basis of the electric-current value obtained from the electric-current value detecting portion 65 (Step S3: YES), at Step S7, it executes the control of opening the switch 46 and also executes control of opening at least either one of the positive-side contactor 75 and the negative-side contactor 76. As a result, the BMU 85 can shut down the electric circuit more reliably. For example, even in a case where the switch 46 is welded and cannot be opened, the BMU 85 can shut down the electric circuit more reliably by opening at least either one of the positive-side contactor 75 and the negative-side contactor 76. As a result, the safety of the battery pack 40 can be further improved.

On the other hand, if the BMU 85 does not detect an overcurrent abnormality (Step S3: NO), at Step S4, the BMU 85 determines whether or not a predetermined time has elapsed since the switch 46 was closed. The "predetermined time" is, as described above in relation with Fig. 1, approximately 8 seconds or more and 12 seconds or less, for example. However, the "predetermined time" is not limited to 8 seconds or more, 12 seconds or less.

If the predetermined time has not elapsed since the BMU 85 closed the switch 46 (Step S4: NO), the BMU 85 executes processing described above in relation with Step S3.

On the other hand, if the predetermined has elapsed since the BMU 85 closed the switch 46 (Step S4: YES), at Step S5, the BMU 85 executes the control of automatically opening the switch 46.

Subsequently, at Step S6, the BMU 85 diagnoses the degradation degree of the battery 50 on the basis of the voltage fluctuation of the battery 50 when the electric current flows from the battery 50 toward the resistor 45.

As shown in Fig. 3, for example, if the electric current flows from the battery 50 toward the resistor 45 only for the predetermined time, the voltage value of the battery 50 detected by the BMU 85 fluctuates. The BMU 85 accumulates voltage fluctuation data of the battery 50, when the electric current flows from the battery 50 toward the resistor 45 as a map M1 in the storage portion 851.

In the map M1 exemplified in Fig. 3, an example of a cell voltage of the battery 50 with SOH (State Of Health) 100% and an example of the cell voltage of the battery 50 of SOH 95% are illustrated. Here, the SOH is an index indicating the degradation degree (that is, soundness and a degradation state) of the battery, and is expressed as follows: SOH = Full-charge capacity at degradation (Ah) / Full-charge capacity at beginning (Ah) x 100

That is, the SOH is a rate of the full-charge capacity (capacity change rate) at the degradation, when the full-charge capacity at the beginning of the battery is assumed to be 100%.

Moreover, for example, as shown in Fig. 4, the BMU 85 estimates a degradation degree H of the battery 50 on the basis of the voltage fluctuation data of the battery 50 in the map M1 accumulated in the storage portion 851. The degradation degree H of the battery 50 estimated by the BMU 85 is made into a graph as exemplified in Fig. 4. In the graph exemplified in Fig. 4, a vertical axis indicates a capacity change rate (percentage) of the battery and a lateral axis indicates the number of years in use. The "capacity change rate" of the vertical axis in the graph exemplified in Fig. 4 corresponds to the SOH (State Of Health) described above.

As a result, as necessary, a service man or a user can make the degradation degree H of the battery 50 into a graph, numerical values or notification light by a display portion (not shown) provided in the battery pack 40 or an external display or the like so as to be recognized. For example, the BMU 85 can execute processing of lighting a display lamp indicating replacement timing of the battery 50, when the capacity change rate of the battery 50 falls to a value determined in advance or less so as to notify the replacement timing of the battery 50.

As explained as above, according to the battery pack 40 according to this embodiment, the resistor 45 is provided in the battery pack 40 and is electrically connected to the battery 50 by the electric circuit. Moreover, the switch 46 is provided at the positive wiring 174 between the battery 50 and the resistor 45 and performs opening / closing of the positive wiring 174 between the battery 50 and the resistor 45. Thus, when the switch 46 closes the positive wiring 174 between the battery 50 and the resistor 45, the electric current flows from the battery 50 toward the resistor 45. Here, the BMU 85 provided in the battery pack 40 executes control of closing the switch 46 in accordance with the input signal 86 and diagnoses the degradation degree of the battery 50 on the basis of the voltage fluctuation of the battery 50, when the electric current flows from the battery 50 toward the resistor 45. As a result, the battery pack 40 according to this embodiment can perform the degradation diagnosis of the battery 50 provided in the battery pack 40 by a single body of the battery pack 40. Moreover, the battery pack 40 according to this embodiment can perform the degradation diagnosis of the battery 50 by a single body of the battery pack 40 and thus, it can perform the degradation diagnosis of the battery 50 by a signal input into the BMU 85 (that is, the input signal 86) at an arbitrary timing, and even in the case where there is no chance for regular inspection such as automobile inspection, for example, the degradation degree of the battery 50 can be diagnosed at the arbitrary timing. As a result, the replacement timing of the battery 50 provided in the battery pack 40 is made clearer.

Moreover, since the BMU 85 executes control of automatically opening the switch 46, when the predetermined time has elapsed since the switch 46 was closed, occurrence of an over-discharge abnormality of the battery 50 can be suppressed.

Moreover, according to the battery pack 40 according to this embodiment, even if a detecting portion for detecting a voltage value of the battery 50 is not provided separately, the BMU 85 can detect the voltage value of the battery 50 by the internal circuit incorporated in the BMU 85 itself. As a result, the structure of the battery pack 40 can be simplified, and size reduction of the battery pack 40 can be promoted.

Moreover, the switch 46 that performs opening / closing of the electric circuit between the battery 50 and the resistor 45 is provided at least at either one of the positive wiring 174 between the positive-side contactor 75 and the resistor 45 and the negative wiring 175 between the negative-side contactor 76 and the resistor 45. Thus, even if an abnormality such as overcurrent abnormality occurs in the electric circuit, for example, the electric circuit on the upstream side of the switch 46 when viewed from the battery 50 is shut down by opening of at least either one of the positive-side contactor 75 and the negative-side contactor 76. As a result, safety of the battery pack 40 can be improved.

Moreover, the BMU 85 diagnoses the degradation degree on the basis of the data of the voltage fluctuation of the battery 50 accumulated in the storage portion 851 and thus, the degradation degree of the battery 50 can be estimated with higher accuracy, and the replacement timing of the battery 50 can be made clearer.

As described above, the embodiment of the present invention has been explained. However, the present invention is not limited to the aforementioned embodiment but is capable of various changes within a range not departing from the scope of claims. The configuration of the aforementioned embodiment can be partially omitted or arbitrarily combined differently from the above.

### [Reference Signs List]

- 1: Engine
- 2: Motor generator
- 10: Hybrid system
- 40: Battery pack
- 45: Resistor
- 46: Switch
- 50: Battery
- 51: Positive terminal
- 52: Negative terminal
- 65: Electric-current value detecting portion
- 75: Positive-side contactor
- 76: Negative-side contactor
- 85: BMU
- 86: Input signal
- 95: Fuse
- 150: ECU
- 174: Positive wiring
- 175: Negative wiring
- 176: Positive branch wiring
- 177: Negative branch wiring
- 181: Signal line
- 182: Signal line
- 183: Signal line
- 184: Signal line
- 185: Signal line
- 193: Signal line
- 851: Storage portion

## Claims

1. A battery pack mounted on a hybrid system, comprising:
a battery that supplies electric power to a motor of the hybrid system;
a resistor electrically connected to the battery by an electric circuit;
a switch provided in the electric circuit between the battery and the resistor and performing opening / closing of the electric circuit between the battery and the resistor; and
a control portion that executes control of closing the switch according to an input signal and diagnoses a degradation degree of the battery on the basis of voltage fluctuation of the battery, when an electric current flows from the battery toward the resistor.

2. The battery pack according to claim 1, wherein
the control portion executes control of automatically opening the switch, when a predetermined time has elapsed since the switch was closed.

3. The battery pack according to claim 1, wherein
the control portion incorporates an internal circuit that detects a voltage value of the battery.

4. The battery pack according to claim 1, further comprising:
a positive-side contactor provided in the electric circuit between a positive terminal of the battery and the resistor and performing opening / closing of the electric circuit between the positive terminal and the resistor; and
a negative-side contactor provided in the electric circuit between a negative terminal of the battery and the resistor and performing opening / closing of the electric circuit between the negative terminal and the resistor, wherein
the switch is provided at least at either one of the electric circuit between the positive-side contactor and the resistor and the electric circuit between the negative-side contactor and the resistor.

5. The battery pack according to claim 4, further comprising:
an electric-current value detecting portion that is provided in the electric circuit and detects an electric-current value flowing through the electric current, wherein
the control portion executes control of opening the switch and executes control of opening at least either one of the positive-side contactor and the negative-side contactor, when the control portion detects an overcurrent abnormality on the basis of the electric-current value obtained from the electric-value detecting portion.

6. The battery pack according to claim 1, wherein
the control portion has a storage portion that accumulates data of the voltage fluctuation and diagnoses the degradation degree on the basis of the data accumulated in the storage portion.
